# FASCICULE DE BREVET EUROPEEN

(11) **EP 1 290 067 B1**
(45) Date de publication et mention de la délivrance du brevet: **22.03.2006**
(21) Numéro de dépôt: 01938352.0
(22) Date de dépôt: 28.05.2001
(51) Int. Cl.: C08J 5/04

(54) **MATERIAUX COMPOSITES FLEXIBLES, ISOLANTS ET THERMIQUEMENT STABLES**
FLEXIBLE, ISOLIERENDE, THERMISCH STABILE VERBUNDMATERIALIEN
FLEXIBLE, INSULATING AND HEAT-STABLE COMPOSITE MATERIALS

(30) Priorité: 29.05.2000 FR 0006821
(43) Date de publication de la demande: 12.03.2003
(73) Titulaire: Von Roll Isola France SA, 69330 Meyzieu (FR)
(72) Inventeur: NODIN, Christian, F-38460 St Romain-de-Jallonas (FR); LEBOURG, Sabine, F-01390 Mionnay (FR); KAMENETZKY, Daniel, F-69480 Pommiers (FR); DUBUISSON, Alain, F-69008 Lyon (FR)
(74) Mandataire: Thibault, Jean-Marc
(86) Numéro de dépôt international: PCT/FR2001/001636
(87) Numéro de publication internationale: WO 2001/092380

(56) Documents cités:
- EP-A- 0 194 653
- EP-A- 0 600 106
- DE-A- 19 757 090
- JP-A- 62 177 012
- US-A- 4 451 529
- US-A- 5 763 503
- PATENT ABSTRACTS OF JAPAN vol. 014, no. 269, 11 juin 1990 (1990-06-11) & JP 02 077749 A (MITSUBISHI KASEI CORP), 16 mars 1990 (1990-03-16)

## Description

La présente invention a pour objet des matériaux composites flexibles, isolants et thermiquement stables qui peuvent être utilisés dans de nombreux domaines sous la forme de feuilles ou de bandes, de préférence déroulables, notamment dans le domaine de l'électronique, par exemple pour les masquages des circuits imprimés lors de la soudure à la vague, des supports électroniques pour cartes à puces ou dans le domaine du marquage électronique de documents d'identification, tels que par exemple des étiquettes électroniques.

On connaît déjà des matériaux composites, qui sont utilisés comme supports de circuits imprimés sous forme de bandes ou de feuilles. Ces matériaux composites sont généralement constitués d'un support et d'une résine. Le support est, le plus souvent, constitué d'un tissu de fibres de verre et la résine est généralement constituée d'un polyester, d'un époxyde ou d'un polymère thermoplastique.

Lorsque le matériau composite, dont le support est en fibres de verre, doit être thermostable, c'est-à-dire résister à des températures supérieures à 150°C environ, on utilise généralement des résines époxydes qui sont réputées pour leurs propriétés mécaniques.

Ces matériaux composites, thermostables, sont généralement obtenus par polymérisation par voie thermique des monomères appropriés sur le support ou par prépolymérisation puis polymérisation.

Malheureusement, les matériaux composites thermostables sont rigides même lorsqu'ils sont de faible épaisseur, ce qui constitue un handicap pour certaines applications, notamment dans le domaines des matériaux en feuilles ou en bandes déroulables.

On a maintenant trouvé de nouveaux matériaux composites qui sont à la fois souples, thermostables et isolants.

Les matériaux composites selon l'invention sont constitués d'au moins un support à base de fibres de verre imprégné d'une résine acrylique et obtenus par réticulation par voie radicalaire grâce à une irradiation UV d'un vernis photoréticulable sur ledit support.

Selon une variante, le matériau composite de l'invention est constitué de deux supports et d'une couche de résine prise en sandwich entre lesdits deux supports.

Selon une autre variante, le matériau composite est un matériau multicouche.

Avantageusement, le support qui convient aux fins de l'invention a une épaisseur de 6 à 1 000 microns, de préférence 20 à 300 microns, et se présente avantageusement sous la forme de rouleaux.

A titre d'exemples de support appropriés aux fins de l'invention, on peut citer les produits à base de fibres de verre, tels que les fils, bandes, mats, rovings, tissus, voiles, nappes.

On peut également utiliser les feutres ou non-tissés à base de verre.

Des exemples de supports appropriés sont notamment les tissus de verre pour stratifiés électroniques et isolation électrique, tels que ceux commercialisés par la Société HEXCEL Fabrics, les non tissés commercialisés par la Société INTERGLAS, lesdits tissus étant à base de fibres de verre, les tissus commercialisés par la Société NORDLYS.

Le vernis photoréticulable utilisé pour la fabrication du matériau composite, selon l'invention est constitué essentiellement :
- d'un oligomère à base d'époxyde, comportant des groupes acrylate ou méthacrylate ;
- d'un photoinitiateur de radicaux libres ;
- éventuellement d'un diluant acrylate ou méthacrylate ;

Le vernis doit présenter une viscosité Brookfield mesurée à 20°C inférieure ou égale à 5 000 mPa.s, comprise de préférence entre 400 et 2 000 mPa.s.

L'oligomère est obtenu en faisant réagir un prépolymère à base d'époxyde, avec de l'acide acrylique ou méthacrylique dans des conditions classiques permettant une addition (réaction de l'acide avec les fonctions époxyde du prépolymère). Voir par example le document DE-A-19757090.

Avantageusement, l'oligomère contient 2 à 5 groupes acrylate ou méthacrylate, de préférence 2 à 3 groupes acrylate ou methacrylate.

Des exemples de prépolymères appropriés aux fins de l'invention sont les composés ci-après :
- les époxydes bisphénol A de poids équivalent en époxy de 182-194 et ayant une viscosité Brookfield à 25°C de 10 000 mPa.s ;
- les résines époxydes novolaques de poids équivalent époxy de 176-181 et ayant une viscosité Brookfield à 50°C de 35 000 mPa.s.

Le diluant acrylate ou méthacrylate éventuellement présent dans le vernis photoréticulable est un acrylate ou méthacrylate de polyol ou d'époxyde ayant une viscosité Brookfield mesurée à 25°C inférieure à 100 mPa.s, de préférence comprise entre 2 à 15 mPa.s. Le diluant contient de préférence 1 à 2 groupes acrylate ou méthacrylate. Le diluant permet d'améliorer la flexibilité ou la souplesse du matériau composite et il limite le retrait lors de la réticulation.

Des exemples d'acrylates appropriés sont le diacrylate d'hexanediol ayant une masse moléculaire de 226 et une viscosité Brookfield mesurée à 25°C de 10 mPa.s ; le monoacrylate d'isobornyle ayant une masse moléculaire de 208 et une viscosité Brookfield mesurée à 25°C de 10 mPa.s.

Le photoinitiateur du vernis photoréticulable est une substance qui initie la formation de radicaux libres sous l'action d'un rayonnement ultraviolet (U.V.) Il est éventuellement combiné avec un agent activateur, qui est de préférence un composé aminé, tel que par exemple la N-méthyldiéthanolamine.

Les longueurs d'onde d'absorption du photoinitiateur sont comprises entre 250 nm et 500 nm, de préférence entre 280 nm et 500 nm.

Des exemples de photoinitiateurs appropriés aux fins de l'invention sont notamment les benzoates, les alkyl-benzophénones ou les propanones, en particulier le 4-diméthylaminobenzoate, la méthylbenzophénone, la 2,4,6-triméthylbenzophénone, le 2-hydroxy-2-méthyl-1-[4-(1-méthylvinyl)phényl] propanone, la 2-hydroxy-2-méthyl-1-phényl-1-propanone ou leurs mélanges. De tels mélanges photoinitiateurs sont commercialisés par exemple par la Société LAMBERTI Spa (Italie) sous la dénomination commerciale ESACURE® et par la Société CIBA Spécialités Chimiques (Suisse) sous la dénomination commerciale IRGAGURE®.

De plus, le vernis photopolymérisable utile selon l'invention peut contenir divers additifs couramment utilisés dans le domaine des vernis et des peintures, tels que notamment des promoteurs d'adhérence sur différents supports métalliques ou plastiques, des agents d'étalement, de lissage, des agents mouillants, des agents débullants, des agents collants, des agents anti-rayure, des agents tensioactifs, des agents plastifiants, des agents tackifiants.

Il appartiendra à l'homme de métier de choisir l'additif approprié en fonction de l'effet recherché.

Le vernis photopolymérisable peut également contenir des pigments ou des charges minérales.

Les proportions pondérales des différents constituants du vernis photoréticulable sont avantageusement les suivantes :
- oligomère 50 à 99,9 parties en poids
- diluant acrylate ou méthacrylate 0 à 60 parties en poids
- photoinitiateur 0,1 à 3 parties en poids
- additifs 0 à 30 parties en poids

Avantageusement, le vernis photopolymérisable a une température de transition vitreuse comprise entre 50 °C et 230 °C.

Le matériau composite selon l'invention peut être préparé par le procédé qui consiste à :
- enduire le vernis photopolymérisable sur au moins l'une des surfaces du support ;
- photoréticuler le vernis sur ledit support à l'aide d'un rayonnement U.V. ayant une longueur d'onde comprise entre 280 et 500 nm.

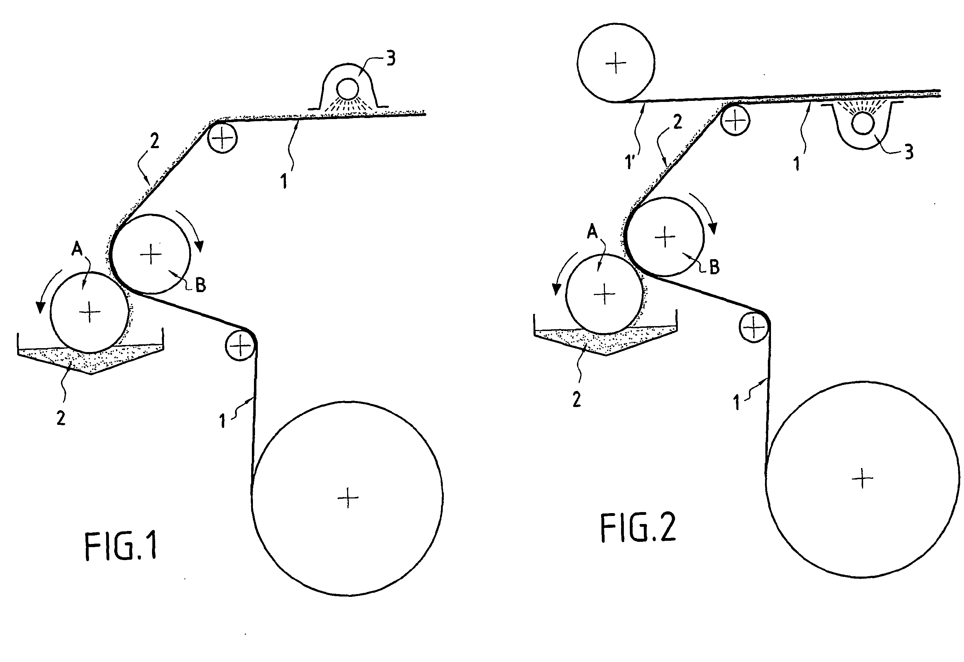

Ce procédé, qui est avantageusement un procédé continu (en ligne), peut être mis en oeuvre selon les modes opératoires représentés sur les Fig.1 et 2 sur lesquelles :
- FIG. 1 est un schéma classique de revêtement d'un support à l'aide d'un vernis et polymérisation U.V.
- FIG. 2 est un schéma classique de fabrication d'un stratifié constitué de deux supports séparés par une couche de vernis et polymérisation U.V.

Selon l'un ou l'autre de ces schémas, le support (1) est imprégné d'une couche de vernis (2) en faisant passer ledit support entre deux tambours (A) et (B), le tambour (A) étant en contact permanent avec le vernis photoréticulable, le tambour (B) tournant dans le sens inverse du tambour (A) permettant d'obtenir un revêtement uniforme du vernis sur ledit support.

Le support ainsi revêtu du vernis est ensuite dirigé vers le rayonnement ultraviolet (3), après avoir éventuellement été revêtu d'un second support (1') selon le mode opératoire représenté sur la Figure 2.

Le matériau composite obtenu après la polymérisation est ensuite stocké sur un cylindre de stockage (non représenté) ou directement découpé en feuilles et emballé selon des procédures classiques.

L'imprégnation du support par le vernis polymérisable est avantageusement réalisée à la température ambiante.

La photopolymérisation U.V. est réalisée à l'aide d'un rayonnement U.V. obtenu avec des lampes ayant une puissance de 100 à 250 W/cm par exemple à l'aide de lampes au mercure de 127 W/cm ou 220 W/cm , de lampes au mercure dopées au fer de 160 W/cm ou de lampes au mercure dopées au gallium de 160 W/cm.

La vitesse de défilement du support/vernis sous le rayonnement U.V. n'est pas critique ; elle varie en fonction des lampes utilisées et de la nature du support. On indiquera toutefois que les vitesses allant de 5 m/min à 20 m/min sont tout à fait appropriées.

Le matériau composite selon l'invention est doué d'excellentes propriétés de stabilité à la chaleur et de souplesse.

Ce matériau convient particulièrement bien comme support de circuits imprimés.

La présente invention va maintenant être décrite plus en détail par les exemples illustratifs ci-après :

### Exemple 1 selon l'invention : matériau composite A

On a utilisé comme support un tissu de verre de 70 à 95 g/m².

On a revêtu ledit support selon le schéma opératoire représenté sur la Figure 1 à l'aide du vernis A dont la composition est la suivante :
50 parties pondérales (pp) d'époxyde novolaque modifié acrylate, dilué dans 30% d'hexanediol diacrylate
50 pp d'acrylate aliphatique
10 pp d'acrylate d'éthyle hexyle
1 pp d'agent débullant
2 pp de photoinitiateur n°1 : "Irgacure 907"
0,2 de photoinitiateur n° 2 : isopropylthioxanthone
La viscosité Brookfield dudit vernis à 20°C était de 550 mPa.s.
Ce matériau composite présentait une souplesse de 172 N/m et une température de transition vitreuse de 160°C.

### Exemple 2 selon l'invention : matériau composite B

On a répété le mode opératoire de l'exemple 1 en utilisant le vernis B ayant la composition ci-après :
68 pp d'époxyde bis-phénol A modifié acrylate
32 pp de diacrylate hexanediol
1 pp d'agent débullant
2 pp de photoinitiateur constitué d'un mélange de benzophénone et d'une propanone (produit connu sous la dénomination commerciale "Esacure KT55".
La viscosité Brookfield dudit vernis à 20°C était de 2 800 mPa.s.
Ce matériau composite présentait une souplesse de 160 N/m et une température de transition vitreuse de 110°C.

### Exemple 3 comparatif : matériau composition C

On a répété le mode opératoire de l'exemple 1 en utilisant le vernis C ayant la composition ci-après :
50 pp d'uréthane aliphatique modifié acrylate
40 pp d'uréthane aromatique modifié acrylate
28 pp d'acrylate éthyle hexyle
10 pp de diacrylate hexanediol
5 pp d'un méthacrylate
2 pp du photoinitiateur utilisé dans l'exemple 2
La viscosité Brookfield dudit vernis à 20°C était de 1 800 mPa.s.
Ce matériau composite présentait une souplesse de 66 N/m et une température de transition vitreuse de 60°C.

### Exemple 4 comparatif : stratifiés D et E

Dans cet exemple, on a utilisé comme premier support un tissu de verre de 70 g/m².
On a revêtu ledit support selon le schéma opératoire représenté sur la Figure 2 avec, soit le vernis D, soit le vernis E ayant les compositions indiquées ci-après, puis on a revêtu ledit ensemble support/vernis d'une feuille de cuivre de 35 microns d'épaisseur :
Vernis D :
   100 pp d'un prépolymère polyester comportant des groupes acrylate.
   5 pp de méthacrylate
   2 pp du photoinitiateur utilisé dans l'exemple 3.
   La viscosité Brookfield dudit vernis à 20°C était de 1 700 mPa.s.
   Le stratifié obtenu présentait une souplesse de 99 N/m et une température de transition vitreuse de 75 °C.
Vernis E :
   56 pp de diacrylate uréthane aromatique
   10 pp de triacrylate isocyanurate
   33 pp d'isobornyl acrylate
   1 pp de phosphate méthacrylé
   2 pp de photoinitiateur n°1 : "IRGACURE 184"
   photoinitiateur n° 2 0,2 pp : "IRGACURE 819"
   La viscosité Brookfield dudit vernis à 20°C était de 3 500 mPa.s.

### Exemple 5 comparatif : matériau composite F et G.

On a répété le mode opératoire de l'exemple 1 en utilisant le vernis B et en remplaçant le tissu de verre par un non-tissé polyester.
Le matériau composite F obtenu avait les caractéristiques ci-après :
- épaisseur de support de 100 microns ;
- température de transition vitreuse de 100 °C ;
- souplesse 72 N/m.
Dans le matériau composite G, le support avait une épaisseur de 70 microns, sa souplesse était de 22 N/m et sa température de transition vitreuse de 70 °C.

### Exemple 6 selon l'invention : matériau composite H

On a répété le mode opératoire de l'exemple 4 en utilisant le vernis A et en complexant 2 tissus de verre de 100 g/m² selon le mode opératoire représenté sur la figure 2.
Le matériau composite H avait une souplesse de 2 390 N/m et une température de transition vitreuse de 149°C.

### Exemple 7 comparatif : matériau composite I

On a répété le mode opératoire de l'exemple 1 en utilisant le vernis A et en remplaçant le tissu de verre par un papier cellulosique de 110 microns.
Le matériau composite obtenu avait une température de transition vitreuse de 150°C et une épaisseur de 140 microns.

### Propriétés :

1 - Les modules élastiques en torsion dynamique des matériaux composites obtenus selon les exemples 1 à 7 ont été déterminés en soumettant l'une des extrémités d'un échantillon rectangulaire de 5 x 15 mm² à une rotation alternative et en mesurant la déformation résultante à l'autre extrémité. Cette détermination est réalisée à l'aide de l'appareil RHEOMETRICS RMS 800/RDS II.
Les résultats obtenus sont les suivants :

| Matériau composite | Modules élastiques en torsion x 10⁷ MPa | |
|---|---|---|
| | à 50°C | à 200°C |
| A | 53 | 19 |
| B | 37 | 8 |
| C | 7 | 4 |
| F | 13 | 4 |
| G | 8 | 2 |
| H | 49 | 20 |
| I | 52 | 27 |

2 - La thermostabilité de ces matériaux composites est constatée en observant les modules à 200 °C et leur valeur élevée.
3 - Les propriétés isolantes des matériaux composites ont été déterminées en mesurant la permitivité et le facteur de dissipation sous une tension de 250 mV à différentes fréquences :

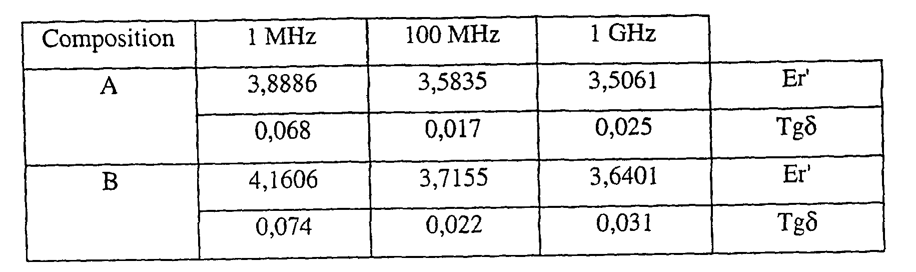

**Mesure de la résistivité superficielle en (M.ohms)**

| Composition | Etat naturel | Après 24 heures dans l'eau à 23°C |
|---|---|---|
| A | 2,6.10⁹ | 3,1.10⁷ |
| B | 2,8.10⁹ | 3,6.10⁶ |

**Mesure de la résistivité transversale en (M.ohms/Cm)**

| Composition | Etat naturel | Après 24 heures dans l'eau à 23°C |
|---|---|---|
| A | 8,4.10¹⁰ | 3,1.10⁸ |
| B | 2,7.10¹⁰ | 3,5.10⁷ |

## Revendications

1. Matériau composite flexible, isolant et thermostable, **caractérisé en ce qu'**il est sous la forme de feuilles, de bandes ou de rouleaux et qu'il est constitué d'au moins un support à base de fibres de verre imprégné d'une résine acrylique, ledit matériau composite étant obtenu par réticulation par voie radicalaire d'un vernis photoréticulable déposé sur ledit support, ledit vernis ayant une viscosité Brookfield mesurée à 20°C inférieure ou égale à 5 000 mPa.s et étant constitué essentiellement :
- d'un oligomère à base d'époxyde, comportant des groupes acrylate ou méthacrylate ;
- d'un photoinitiateur de radicaux libres ;
- éventuellement d'un diluant acrylate ou méthacrylate.

2. Matériau composite selon la revendication 1, **caractérisé en ce que** le diluant acrylate ou méthacrylate a une viscosité Brookfield mesurée à 25°C inférieure à 100 mPa.s.

3. Matériau composite selon la revendication 1 ou 2, **caractérisé en ce que** le vernis contient en outre un ou plusieurs additifs parmi les agents d'étalement, de lissage, des agents mouillants, des agents débullants, des agents collants, des agents anti-rayure, des agents tensioactifs, des agents plastifiants, des agents tackifiants.

4. Matériau composite selon l'une quelconque des revendications 1 à 3, **caractérisé en ce que** le vernis photoréticulable contient :
- 50 à 99,9 parties en poids d'oligomère
- 0 à 60 parties en poids de diluant acrylate ou méthacrylate
- 0,1 à 3 parties en poids de photoinitiateur
- 0 à 30 parties en poids d'additifs

5. Matériau composite selon l'une quelconque des revendications 1 à 4, **caractérisé en ce qu'**il a une température de transition vitreuse comprise entre 50°C et 230°C.

6. Procédé continu pour l'obtention d'un matériau composite flexible selon l'une des revendications 1 à 5, isolant et thermostable constitué d'un support imprégné d'une résine acrylique, **caractérisé en ce qu'**il consiste à :
- enduire le vernis photoréticulable sur au moins l'une des surfaces du support ;
- photoréticuler le vernis sur ledit support à l'aide d'un rayonnement U.V. ayant une longueur d'onde comprise entre 280 et 500 nm.

7. Utilisation d'un matériau selon l'une quelconque des revendications 1 à 5 pour les masquages des circuits imprimés lors de la soudure à la vague ou des supports électroniques pour cartes à puces, dans le domaine du marquage électronique.

## Claims

1. Flexible, insulating and heat-stable composite material, **characterized in that** it is in the form of sheets, strips or rolls and consists of at least one glass fibre-based support impregnated with an acrylic resin, said composite material being obtained by radical cross-linking of a photo-cross-linkable varnish deposited on said support, said varnish having a Brookfield viscosity measured at 20°C of 5000 mPa.s and essentially consisting of:
- an epoxide-based oligomer containing acrylate or methacrylate groups,
- a photoinitiator of free radicals;
- optionally an acrylate or methacrylate thinner.

2. Composite material as in claim 1, **characterized in that** the acrylate or methacrylate thinner has a Brookfield viscosity measured at 25°C of less than 100 mPa.s.

3. Composite material as in claim 1 or 2, **characterized in that** the varnish also contains one or more additives from among flow agents, smoothing agents, wetting agents, degassing agents, sticking agents, anti-scratch agents, surfactants, plasticizing agents, tackifying agents.

4. Composite material as in any of claims 1 to 3, **characterized in that** the photo-cross-linkable varnish contains:
- 50 to 99.9 parts by weight of oligomer,
- 0 to 60 parts by weight of acrylate or methacrylate thinner,
- 0.1 to 3 parts by weight of photoinitiator
- 0 to 30 parts by weight of additives

5. Composite material as in any of claims 1 to 4, **characterized in that** it has a glass transition temperature of between 50°C and 230°C.

6. Continuous method for obtaining a flexible composite material as in any of claims 1 to 5 that is insulating and heat-stable consisting of a support impregnated with an acrylic resin, **characterized in that** it entails:
- coating the photo-cross-linkable varnish on at least one of the surfaces of the support
- photo-cross-linking the varnish on said support using UV radiation with a wavelength of between 280 and 500 nm.

7. Use of a material as in any of claims 1 to 5 for masking printed circuits during wave soldering or electronic supports of smart cards in the area of electronic marking.

## Patentansprüche

1. Flexibles, isolierendes und wärmestabiles Kompositmaterial, **dadurch gekennzeichnet, daß** es in Form von Blättern, Bändern oder Rollen vorliegt, und daß es wenigstens aus einem Träger auf Glasfaserbasis, imprägniert mit einem Acrylharz, besteht, wobei das Kompositmaterial erhalten wird durch Vernetzung auf radikalischem Wege von einem fotovernetzbaren Lack, abgeschieden auf dem Träger, wobei der Lack eine Brookfield-Viskosität, gemessen bei 20°C, kleiner oder gleich 5.000 mPa.s hat und im wesentlichen besteht aus:
- einem Oligomer auf Epoxidbasis, das Acrylat- und Methacrylatgruppen umfaßt;
- einem Fotostarter mit freien Radikalen;
- gegebenenfalls einem Acrylat- oder Methacrylatverdünnungsmittel.

2. Kompositmaterial nach Anspruch 1, **dadurch gekennzeichnet, daß** das Acrylat- oder Methacrylatverdünnungsmittel eine Brookfield-Viskosität, gemessen bei 25°C unter 100 mPa.s hat.

3. Kompositmaterial nach Anspruch 1 oder 2, **dadurch gekennzeichnet, daß** der Lack außerdem einen oder mehrere Zusätze enthält, gewählt unter den Aufstreichmitteln, Glättungsmitteln, Befeuchtungsmitteln, Entgasungsmitteln, Klebemitteln, Faltenverhinderern, Tensiden, Weichmachern, Klebrigmachern (Tackifiern).

4. Kompositmaterial nach einem der Ansprüche 1 bis 3, **dadurch gekennzeichnet, daß** der fotovernetzbare Lack enthält:
- 50 bis 99,9 Gewichtsteile Oligomer
- 0 bis 60 Gewichtsteile Acrylat- oder Methacrylatverdünnungsmitel
- 0,1 bis 3 Gewichtsteile Fotoinitiator
- 0 bis 30 Gewichtsteile Zusätze.

5. Kompositmaterial nach einem der Ansprüche 1 bis 4, **dadurch gekennzeichnet, daß** die Glasübergangstemperatur zwischen 50°C und 230°C liegt.

6. Kontinuierliches Verfahren zum Erhalt eines flexiblen Kompositmaterials nach einem der Ansprüche 1 bis 5, das isolierend und wärmestabil ist, bestehend aus einem imprägnierten Träger eines Acrylharzes, **dadurch gekennzeichnet, daß** es besteht darin:
- den fotovernetzbaren Lack auf wenigstens einer der Oberflächen des Trägers zu übergießen;
- den Lack auf dem Träger mit Hilfe von UV-Strahlung mit einer Wellenlänge zwischen 280 und 500 nm fotochemisch zu vernetzen.

7. Verwendung eines Materials nach einem der Ansprüche 1 bis 5 für das Maskieren gedruckter Schaltkreise beim Anschwemmlöten oder elektronische Träger für Chipkarten auf dem Gebiet der elektronischen Kennzeichnung.
